# EUROPEAN PATENT SPECIFICATION

(11) **EP 3 699 614 B1**
(45) Date of publication and mention of the grant of the patent: **28.08.2024**
(21) Application number: 20382124.4
(22) Date of filing: 21.02.2020
(51) Int. Cl.: G01R 31/12

(54) **METHOD AND SYSTEM OF PARTIAL DISCHARGE RECOGNITION FOR DIAGNOSING ELECTRICAL NETWORKS**
VERFAHREN UND SYSTEM ZUR TEILENTLADUNGSERKENNUNG ZUR DIAGNOSE ELEKTRISCHER NETZWERKE
PROCÉDÉ ET SYSTÈME DE RECONNAISSANCE DE DÉCHARGE PARTIELLE POUR DIAGNOSTIQUER DES RÉSEAUX ÉLECTRIQUES

(30) Priority: 22.02.2019 ES 201930149
(43) Date of publication of application: 26.08.2020
(73) Proprietor: Ormazabal Corporate Technology, A.I.E., 48340 Amorebieta-Etxano (Vizcaya) (ES)
(72) Inventor: BARRIOS PEREIRA, Sonia, Raquel, 48340 Amorebieta-Etxano (Vizcaya) (ES); GILBERT, Ian Paul, 48340 Amorebieta-Etxano (Vizcaya) (ES)
(74) Representative: Herrero & Asociados, S.L.

(56) References cited:
- EP-A1- 2 725 367
- CN-A- 105 137 310
- CN-A- 107 449 994
- CN-A- 108 983 051
- CN-A- 109 061 426
- CN-A- 109 116 203
- KR-B1- 101 822 829
- US-A1- 2011 077 484
- US-A1- 2013 211 750
- ANONYMOUS: "A guide for using the Wavelet Transform in Machine Learning - ML Fundamentals", 21 December 2018 (2018-12-21), XP093002106, Retrieved from the Internet <URL:https://ataspinar.com/2018/12/21/a-guide-for-using-the-wavelet-transform-in-machine-learning/> [retrieved on 20221125]
- SURESH D: "Feature Extraction for Multi Source Partial Discharge Pattern Recognition", INDICON, 2005 ANNUAL IEEE CHENNAI, INDIA 11-13 DEC. 2005, PISCATAWAY, NJ, USA,IEEE, 11 December 2005 (2005-12-11), pages 309 - 312, XP010890554, ISBN: 978-0-7803-9503-9, DOI: 10.1109/INDCON.2005.1590179

## Description

### OBJECT OF THE INVENTION

The partial discharge recognition method, specifically for diagnosing live electrical networks, allows the recognition of partial discharge sources using an existing convolutional neural network, previously adapted and subsequently trained by means of graphic representations of real partial discharge signals from known and acquired sources in electrical networks.

### BACKGROUND TO THE INVENTION

A partial discharge is a phenomenon of dielectric breakdown that is confined and located in the region of an insulating medium, between two conductors that are at different potential. Partial discharge phenomena are in most cases due to insulation defects in the elements that are part of an electrical network, and these elements may consist of, for example, cables, transformers, switches, electrical connections, etc.

Partial discharges can be characterized in three types depending on the properties of the medium between the conductive parts. They can be external, also called corona, which normally occur by the process of ionization of the air contained between the conductive parts. They can also be superficial, produced on the contact surface of two different insulating materials, or they can be internal, produced in internal cavities of a solid dielectric material.

Partial discharges have harmful effects on the environment in which they occur. In a solid or liquid medium, they produce a slow but continuous degradation, which ends in the total dielectric breakdown of the insulating medium. In a gaseous medium, such as air, partial discharges produce the well-known corona discharge, which has consequences that can be directly observed by sight, sound or smell. However, there are other consequences that are not detectable with the naked eye, such as heat generation, power losses, mechanical erosion of the surfaces that are ionically bombarded, interference with radio waves, etc.

If they occur and go unnoticed, they can have very serious consequences. Replacement or repair of damaged electrical network elements can be very costly and can result in a network outage over a long period of time, as well as mean significant economic losses for the electricity companies. The key to preventing any possible problems is the detection and recognition of partial discharges. Recognition of partial discharges can help to avoid risks and carry out proper maintenance of the installations. In short, performing a thorough control can save a great deal of time and money.

There are methods of partial discharge recognition based on artificial neural networks, such as a convolutional neural network (CNN), which is a type of artificial neural network effective for image recognition and classification tasks. CNNs require relatively little pre-processing of signals compared to other image classification algorithms. This means that this neural network learns particular features of the signals that in traditional algorithms are designed by hand. This independence from previous knowledge and human effort in the design of the representative features of a PD signal is a characteristic of CNNs that provides a great advantage over other neural networks.

In relation to this type of neural network, where the input values must be images, recent studies show that CNNs have improved their performance in classifying partial discharges, that is, in their function of recognizing the sources of partial discharges. CNNs have to be previously trained by means of images that represent the signals of known partial discharge sources, and in this sense, there are examples of partial discharge recognition methods that use as input for CNN training images of simulated partial discharge signals, i.e. not acquired from a power grid. However, the use of non-real signals in the CNN training step has the disadvantage that later, when performing recognition of signals acquired by sensors in the field, the accuracy of the result or "output" obtained is lower or the result is less reliable. On the contrary, there are other examples in which images of real partial discharge signals acquired by sensors in the field are used as input for CNN training, thus increasing the accuracy of the results obtained in partial discharge recognitions.

In order to obtain the images that represent the real partial discharge signals acquired by sensors in the field, there are partial discharge recognition methods where a post-processing is applied to these signals. Common post-processing techniques are based on the analysis of PD signals in the time domain, the frequency domain or a combination of both domains.

In the case of the time domain, it is possible to extract characteristics of the signal waveform, such as event occurrence, amplitude, rise time, fall time, duration, etc. The PRPD (technique called "phase-resolved partial discharge") is a technique that performs an analysis based on the time domain to obtain a picture of the partial discharge events with respect to the power wave, and consists of representing in a three-dimensional diagram three components; Φ, q, n, which represent respectively the phase, the charge and the number of partial discharge occurrences during a given time. The generation of these patterns will depend on the partial discharge rate in each cycle and the number of cycles considered to have a representative pattern, so it comprises the inconvenience that the recording time for each type of partial discharge is very subjective. This pattern is also strongly influenced by the external noise and by the voltage of the electrical network, so the ambiguity of this image would be a problem to train a CNN correctly. The article by Suresh D, "Feature Extraction for Multi Source Partial Discharge Pattern Recognition", IEEE Indicon 2005 Conference, Chennai, India, 11-13 December 2005, pages 309-312, discloses such a PRPD technique.

In the case of frequency domain analysis of PD signals, there are techniques such as Fourier Transform (FT) that allow the determination of the frequency components of the PD signal. However, Fourier Transform (FT) is not efficient for analyzing partial discharges because it ignores or misestimates the rapid variations in signal frequency. Fourier Transform is widely used in signal processing and analysis with satisfactory results where these signals are periodic and regular enough, but not for signal processing and analysis where the spectrum varies over time (non-periodic signals). The Fourier Transform detects the presence of a certain frequency, but does not provide information about the evolution over time of the spectral characteristics of the signal. Many temporal aspects of the signal, such as the beginning and end of a finite signal and the instance of appearance of a singularity in a transient signal, cannot be adequately analyzed by Fourier analysis.

However, other techniques combine time-frequency analysis and provide information on the amplitude and energy concentration levels of the signal in the time-frequency spectrum. That is, they simultaneously provide the time and frequency characteristics of the signal. In this sense, it is possible to graphically represent a PD signal by means of a spectrogram obtained by applying the Short-Time Fourier Transform (STFT) to the PD signal. The STFT is one of the most common for time-frequency analysis. In this technique, the signal under study is divided into segments that are multiplied by a window function and then the classical Fourier Transform (FT) is calculated. STFT is easy to implement, but for the analysis of time-varying signals it provides low resolution. The structure of the spectrogram itself requires a resolution of the signal in time and frequency. Choosing the short analysis window guarantees good time localization, but at the expense of poor frequency resolution (due to Fourier duality) and vice versa. Furthermore, once an analysis window has been chosen, the resolution capabilities of the Spectrogram remain fixed for all time and frequency parameters.

In short, by using the previously mentioned techniques in the post-processing of the signals for the CNN input, a graphic representation of the signals is obtained that is not very representative of the partial discharge phenomenon and consequently the output or result of the CNN has little precision or is not reliable.

Examples of the state of the art can be cited regarding recognition methods in which the neural network used is a CNN and where this CNN is trained with images that represent real partial discharge signals acquired by sensors in the field. Thus, documents US2015301102A1, CN107907799A and CN107238507A can be mentioned. In the recognition methods defined in them, Fourier Transform is used in the post-processing of the signals and, therefore, as mentioned above, the graphic representation of the signals lacks resolution and therefore the reliability of the CNN result is very low.

Document US2013211750 discloses a method specially designed for detecting events associated with partial discharges (PDs) in high voltage cables includes the identification of the location and the evaluation of the amplitude and rate of repetition per period of the grid voltage, with the possibility of identifying different sources producing PD signals as a function of the location thereof and recognizing the type of defect associated with PDs in the same location. Generated electric signals are measured and the discriminated in relation to the background noise. A system for carrying out the method includes devices for discriminating the noise in relation to the transient waveform of the PD, determining the parameters associated therewith, determining the map of sources of PDs along the length of the cable, graphically representing the sources, and identifying the patterns of the sources of PDs separated as a function of the location thereof along the length of the cable.

CN107449994A, CN109061426A, CN108983051A, EP2725367A1, CN105137310A, KR101822829B1 and CN109116203A disclose other known methods for partial discharge recognition.

### DESCRIPTION OF THE INVENTION

The present invention refers to a method as defined in claim 1 of recognizing partial discharges, also referred as PD, in particular for diagnosing live electrical networks, which is intended to solve each and every one of the problems mentioned above. This method comprises a series of steps, among which there is a signal post-processing step, which by combining this step and a convolutional neural network (CNN), makes it possible to recognize the sources of partial discharges with a high degree of accuracy, so that it helps in the management of the facilities, understanding by management all those tasks that allow the optimization of the maintenance of the electrical network, determining where to carry out an intervention with the purpose of avoiding faults, service outages that leave the consumers without electrical supply, and minimizing the costs for the electrical companies providing them with different analyses, alarms, etc.

The method of recognizing partial discharges generally comprises the following steps:
- Acquisition of at least one partial discharge signal through at least one sensor,
- Pre-processing of the PD signal acquired through the sensor,
- Post-processing of the pre-processed and acquired PD signal through the sensor, comprising the step of obtaining a PD signal scalogram based on a Wavelet Transform, and
- Recognition of the scalogram image of the post-processed partial discharge signal by a neural network, the neural network being a convolutional neural network.

More specifically, PD signals are acquired by sensors and are actual PD signals acquired by sensors in the field, such as signals produced by an insulation failure that are captured by e.g. capacitive or inductive sensors installed in the power grid. These signals acquired in a next step are pre-processed, i.e. a first filtering or processing of the signals is carried out in order to delimit these signals within a frequency range and eliminate electrical noise.

The recognition method also comprises a post-processing step of the PD signals pre-processed in the previous step. This post-processing step refers to a second filtering or processing of the signals, where a scalogram is obtained, i.e. a high-resolution image or graphical representation in the frequency and time spectrum of the PD signals, using a well-known technique called Wavelet Transform. By means of the Wavelet Transform, a good location of the PD signals in time and frequency is established, so that by means of this technique one of the fundamental problems in the treatment of the signals is faced, such as the reduction of electrical noise, in such a way that a representation or image of the PD signals with greater resolution in the time and frequency domain is obtained, avoiding problems of analysis of the non-stationary signals and of fast transience, and mapping the signals in a time-frequency representation.

In addition, the method object of the invention also comprises a step of construction of a library of partial discharge signals from known sources, these signals having been acquired, pre-processed and post-processed in the previous steps. These signals are subsequently employed in another step comprising the method for the training of the convolutional neural network (CNN).

However, prior to the training of the convolutional neural network (CNN), the method of recognition of the invention comprises an adaptation step (15) of the neural network, since the convolutional neural network (CNN) employed refers to an existing neural network, that is, it is not a neural network constructed expressly for use in the method of the present invention. This adaptation step (15) of the neural network makes it possible to adapt the input parameters of the neural network according to the format of the post-processed signals (input) and the output parameters of the neural network according to the desired objectives.

Once the existing convolutional neural network (CNN) has been adapted, the next step is the training of this neural network, using the library of partial discharge signals from known sources. In this way, with the trained convolutional neural network (CNN), it can receive image inputs representing PD signals from unknown sources and provide highly accurate results in the identification of such sources.

Finally, these results obtained in a subsequent step of verification of the partial discharges recognized by the convolutional neuronal network (CNN) allows the relevant actions of maintenance of the electrical network to be taken, as well as provide feedback to the library of partial discharge signals from known sources by means of these new results, thus ensuring greater accuracy in future recognitions. This step of verification of the partial discharges recognized by the convolutional neuronal network (CNN) refers to the verification by an operator in-situ (in field) of the result provided by the CNN. If the operator confirms that the result is accurate, it is included in the library along with the known PD signals. If the operator confirms that the result is not successful, it will also be included in the library as a new source of PD signals.

In accordance with another object of the invention, a partial discharge recognition system as defined in claim 7 is described below where the above described recognition method is applicable.

The system comprises a recognition unit comprising a first module for post-processing PD signals and a second module corresponding to the neural network, such as a convolutional neural network (CNN). The first post-processing module feeds the second module of the convolutional neural network (CNN) through high-resolution inputs of PD signals, so that the combination of both modules allows highly accurate outputs or results to be obtained. Likewise, the recognition unit comprises a third module corresponding to the library of partial discharge signals from known sources, as well as a fourth module for training the convolutional neural network (CNN) and a fifth module for verifying the partial discharges recognized by the second neural network module.

Finally, the PD recognition system comprises a PD signal acquisition unit, such as a sensor, and a pre-processing unit for the PD signals acquired by the acquisition unit.

### FIGURE DESCRIPTION

Figure 1.- Shows a block diagram of the partial discharge recognition method of the present invention.
Figure 2.- Shows a block diagram of the partial discharge recognition system where the recognition method of Figure 1 applies.

### PREFERRED EMBODIMENT OF THE INVENTION

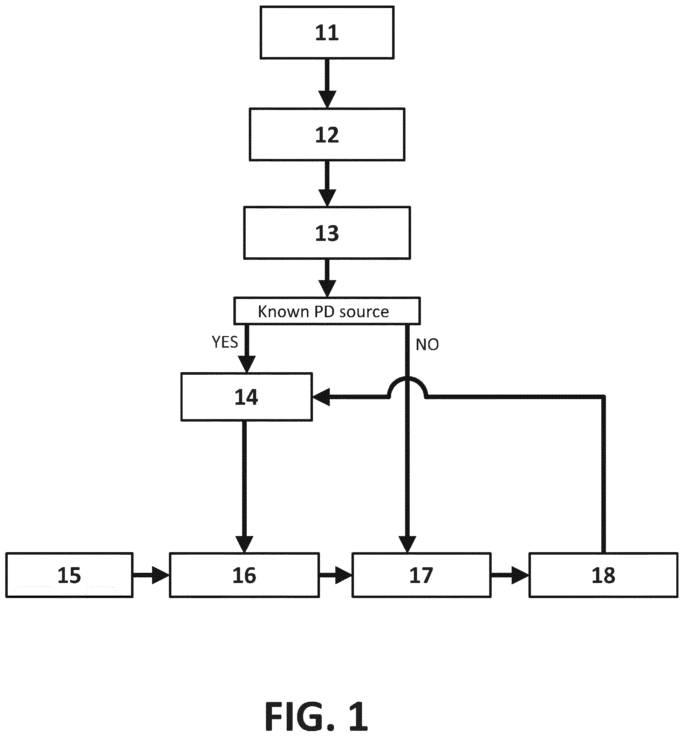

An example of a preferred embodiment is described below, mentioning the figures above, without limiting or reducing the scope of protection of the present invention. Figure 1 shows a method of recognizing partial discharge signals based on the use of an existing convolutional neural network (CNN), so that this method also defines the steps to be followed for the adaptation (15) and training (16) of the existing neural network by means of partial discharge signals from known sources.

In the adaptation step (15) of the existing convolutional neural network (CNN), the input parameters of the neural network are adapted according to the format of the input signals and the output parameters of the neural network according to the desired objectives.

The method comprises an acquisition step (11) of at least one real PD signal through at least one sensor (1) in the field. This acquired signal is then subjected to a first filtering in a pre-processing step (12) and then to a second filtering in a post-processing step (13) using the Wavelet Transform, thus obtaining a high resolution scalogram or graphical representation (image) of the PD signal in the frequency and time spectrum.

In the case of PD signals from known sources, once the signals have passed through the post-processing step (13), in a following step (14) a library is built which includes all these PD signals from known sources. This library of PD signals from known sources is used in a subsequent training step (16) of the convolutional neural network (CNN), so that, with the trained CNN, inputs (images) of PD signals from unknown sources can be received and provide outputs or results with a high degree of accuracy in the identification of such sources.

As can be seen in Figure 1, the partial discharge recognition method of the invention comprises the following application steps in signals from unknown sources and for the identification of the same:
- Acquisition (11) of at least one partial discharge signal through at least one sensor (1),
- Pre-processing (12) of the PD signal acquired through the sensor (1),
- Post-processing (13) of the pre-processed and acquired partial discharge signal through the sensor (1),
- Recognition (17) by the convolutional neural network (CNN) of the post-processed partial discharge signal, and
- Verification (18) of the partial discharge recognized by the convolutional neural network (CNN).

Once the PD signals have been verified and accepted, they are incorporated into the library of PD signals from known sources, expanding that library with new data that will ensure greater accuracy in future recognitions. This verification step (18) of partial discharges recognized by the convolutional neural network (CNN) refers to the verification by an on-site operator of the result provided by the CNN. If the operator confirms that the result is accurate, it is included in the library along with the known partial discharge signals. If the operator confirms that the result is not successful, it will also be included in the library as a new source of PD signals.

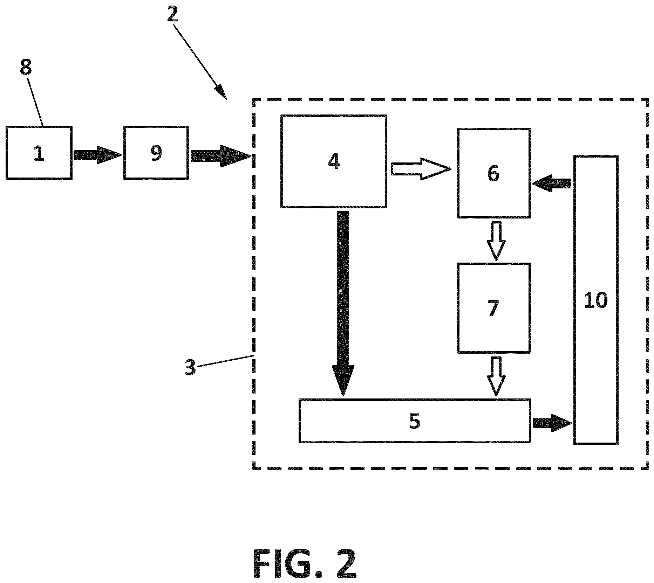

Figure 2 shows the partial discharge recognition system (2) where the method described above is applicable. The partial discharge recognition system (2) comprises a recognition unit (3) that in turn comprises a first post-processing module (4) of partial discharge signals and a second module (5) corresponding to the neural network, such as a convolutional neural network (CNN). The first post-processing module (4) feeds the second module (5) of the convolutional neural network (CNN) through high-resolution inputs (images) of PD signals, so that the combination of both modules (4, 5) allows to obtain highly accurate results. In addition, the recognition unit (3) comprises a third module (6) corresponding to the library of partial discharge signals from known sources, as well as a fourth module (7) for training of the convolutional neural network (CNN) and a fifth module (10) for verification of the partial discharges recognized by the second neural network module (5).

Finally, the PD recognition system (2) comprises a PD signal acquisition unit (8), such as a sensor (1), and a pre-processing unit (9) of the PD signals acquired by the acquisition unit (8).

## Claims

1. Method of partial discharge recognition for diagnosing live electrical networks which comprises the following steps:
- acquisition (11) of at least one partial discharge, PD, signal through at least one sensor (1),
- pre-processing (12) of the PD signal acquired through the sensor (1), in order to delimit the PD signal within a frequency range and to eliminate electrical noise.
- post-processing (13) of the pre-processed PD signal acquired through the sensor (1), and
- recognition (17) of the scalogram image of the post-processed partial discharge signal by a neural network,
the method being **characterised in that**:
- the post-processing step (13) of the PD signal comprises a step for obtaining a PD signal scalogram based on a Wavelet Transform, and
- the recognition neural network is a convolutional neural network.

2. Method of partial discharge recognition according to claim 1, **characterized in that** it further comprises an adaptation step (15) of the convolutional neuronal network.

3. Method of partial discharge recognition according to claim 1, **characterized in that** it further comprises a step of construction of a library (14) of partial discharge signals from known sources.

4. Method of partial discharge recognition according to claim 3, **characterized in that** it further comprises a training step (16) of the convolutional neural network through the library of partial discharge signals from known sources.

5. Method of partial discharge recognition according to claim 4, **characterized in that** it further comprises a verification step (18) of the partial discharge recognized by the convolutional neural network.

6. Method of partial discharge recognition according to claim 5, **characterised in that** the verified partial discharge signals are incorporated into the partial discharge signal library.

7. Partial discharge recognition system (2) for diagnosing live electrical networks, said partial discharge recognition system (2) being configured to carry out the method according to the previous claims 1 to 6, and comprising:
- a PD acquisition unit (8) comprising at least one sensor (1), for acquiring at least one partial discharge (PD) signal through said at least one sensor (1),
- a pre-processing unit (9) for pre-processing (12) of the PD signal acquired through the sensor (1), in order to delimit the PD signal within a frequency range and to eliminate electrical noise, and
- a recognition unit (3),
said recognition unit (3) comprising:
- a first post-processing module (4) of partial discharge signals for post-processing (13) of the pre-processed PD signal acquired through the sensor (1) by obtaining a PD signal scalogram based on a Wavelet Transform, and
- a second neural network module (5) for recognizing (17) the scalogram image of the post-processed partial discharge signal by a neural network, said recognition neural network being a convolutional neural network.

8. Partial discharge recognition system (2) according to claims 7, **characterised in that** the recognition unit (3) comprises a third module (6) of partial discharge signal library from known sources.

9. Partial discharge recognition system (2) according to claim 8, **characterized in that** the recognition unit (3) comprises a fourth module (7) of convolutional neural network training.

10. Partial discharge recognition system (2) according to claim 9, **characterized in that** the recognition unit (3) comprises a fifth module (10) of verification of the partial discharges recognized by the second module (5) of the neural network.

## Patentansprüche

1. Verfahren zur Teilentladungserkennung zur Diagnose von unter Spannung stehenden elektrischen Netzen, das die folgenden Schritte umfasst:
- Erfassung (11) von mindestens einem Teilentladungsignal, TE-Signal, durch mindestens einen Sensor (1),
- Vorbearbeitung (12) des durch den Sensor (1) erfassten TE-Signals, um das TE-Signal innerhalb eines Frequenzbereichs abzugrenzen und elektrisches Rauschen zu eliminieren,
- Nachbearbeitung (13) des vorbearbeiteten TE-Signals, das durch den Sensor (1) erfasst wurde, und
- Erkennung (17) des Skalogrammbildes des nachbearbeiteten Teilentladungssignals durch ein neuronales Netz,
wobei das Verfahren **dadurch gekennzeichnet ist, dass**:
- der Nachbearbeitungsschritt (13) des TE-Signals einen Schritt zum Erhalten eines TE-Signal-Skalogramms basierend auf einer Wavelet-Transformation umfasst, und
- das neuronale Erkennungsnetz ein Convolutional Neural Network ist.

2. Verfahren zur Teilentladungserkennung nach Anspruch 1, **dadurch gekennzeichnet, dass** es ferner einen Anpassungsschritt (15) des Convolutional Neuronal Network umfasst.

3. Verfahren zur Teilentladungserkennung nach Anspruch 1, **dadurch gekennzeichnet, dass** es ferner einen Schritt der Konstruktion einer Bibliothek (14) von Teilentladungssignalen aus bekannten Quellen umfasst.

4. Verfahren zur Teilentladungserkennung nach Anspruch 3, **dadurch gekennzeichnet, dass** es ferner einen Trainingsschritt (16) des Convolutional Neural Network durch die Bibliothek von Teilentladungssignalen aus bekannten Quellen umfasst.

5. Verfahren zur Teilentladungserkennung nach Anspruch 4, **dadurch gekennzeichnet, dass** es ferner einen Verifikationsschritt (18) der von dem Convolutional Neural Network erkannten Teilentladung umfasst.

6. Verfahren zur Teilentladungserkennung nach Anspruch 5, **dadurch gekennzeichnet, dass** die verifizierten Teilentladungssignale in die Teilentladungssignalbibliothek aufgenommen werden.

7. Teilentladungserkennungssystem (2) zur Diagnose von unter Spannung stehenden elektrischen Netzen, wobei das Teilentladungserkennungssystem (2) dazu ausgebildet ist, das Verfahren nach den voranstehenden Ansprüchen 1 bis 6 auszuführen, und umfasst:
- eine TE-Erfassungseinheit (8), die mindestens einen Sensor (1) aufweist, um mindestens ein Teilentladungssignal durch den mindestens einen Sensor (1) zu erfassen,
- eine Vorbearbeitungseinheit (9) zur Vorbearbeitung (12) des durch den Sensor (1) erfassten TE-Signals, um das TE-Signal innerhalb eines Frequenzbereichs abzugrenzen und elektrisches Rauschen zu eliminieren, und
- eine Erkennungseinheit (3),
wobei die Erkennungseinheit (3) umfasst:
- ein erstes Nachbearbeitungsmodul (4) von Teilentladungssignalen zur Nachbearbeitung (13) des vorbearbeiteten TE-Signals, das durch den Sensor (1) erfasst wurde, durch Erhalten eines TE-Signal-Skalogramms basierend auf einer Wavelet-Transformation, und
- ein zweites Neuronales-Netz-Modul (5) zur Erkennung (17) des Skalogrammbildes des nachbearbeiteten Teilentladungssignals durch ein neuronales Netz, wobei das neuronale Erkennungsnetz ein Convolutional Neural Network ist.

8. Teilentladungserkennungssystem (2) nach Anspruch 7, **dadurch gekennzeichnet, dass** die Erkennungseinheit (3) ein drittes Modul (6) einer Teilentladungssignalbibliothek aus bekannten Quellen umfasst.

9. Teilentladungserkennungssystem (2) nach Anspruch 8, **dadurch gekennzeichnet, dass** die Erkennungseinheit (3) ein viertes Modul (7) für Convolutional Neural Network Training umfasst.

10. Teilentladungserkennungssystem (2) nach Anspruch 9, **dadurch gekennzeichnet, dass** die Erkennungseinheit (3) ein fünftes Modul (10) zur Verifikation der vom zweiten Modul (5) des neuronalen Netzes erkannten Teilentladungen umfasst.

## Revendications

1. Procédé de reconnaissance de décharge partielle pour le diagnostic de réseaux électriques sous tension qui comprend les étapes suivantes :
- l'acquisition (11) d'au moins un signal de décharge partielle, PD, par le biais d'au moins un capteur (1),
- le prétraitement (12) du signal PD acquis par le biais du capteur (1), afin de délimiter le signal PD au sein d'une plage de fréquences et d'éliminer un bruit électrique,
- le post-traitement (13) du signal PD prétraité acquis par le biais du capteur (1), et
- la reconnaissance (17) de l'image de scalogramme du signal post-traité de décharge partielle par un réseau neuronal,
le procédé étant **caractérisé en ce que** :
- l'étape de post-traitement (13) du signal PD comprend une étape d'obtention d'un scalogramme de signal PD sur la base d'une transformée en ondelettes, et
- le réseau neuronal de reconnaissance est un réseau neuronal à convolution.

2. Procédé de reconnaissance de décharge partielle selon la revendication 1, **caractérisé en ce qu'**il comprend en outre une étape d'adaptation (15) du réseau neuronal à convolution.

3. Procédé de reconnaissance de décharge partielle selon la revendication 1, **caractérisé en ce qu'**il comprend en outre une étape de construction d'une bibliothèque (14) de signaux de décharge partielle provenant de sources connues.

4. Procédé de reconnaissance de décharge partielle selon la revendication 3, **caractérisé en ce qu'**il comprend en outre une étape d'entraînement (16) du réseau neuronal à convolution par le biais de la bibliothèque de signaux de décharge partielle provenant de sources connues.

5. Procédé de reconnaissance de décharge partielle selon la revendication 4, **caractérisé en ce qu'**il comprend en outre une étape de vérification (18) de la décharge partielle reconnue par le réseau neuronal à convolution.

6. Procédé de reconnaissance de décharge partielle selon la revendication 5, **caractérisé en ce que** les signaux de décharge partielle vérifiés sont incorporés dans la bibliothèque de signaux de décharge partielle.

7. Système de reconnaissance de décharge partielle (2) pour le diagnostic de réseaux électriques sous tension, ledit système de reconnaissance de décharge partielle (2) étant configuré pour mettre en oeuvre le procédé selon les revendications 1 à 6 précédentes, et comprenant :
- une unité d'acquisition de PD (8) comprenant au moins un capteur (1), pour l'acquisition d'au moins un signal de décharge partielle (PD) par le biais dudit au moins un capteur (1),
- une unité de prétraitement (9) pour le prétraitement (12) du signal PD acquis par le biais du capteur (1), afin de délimiter le signal PD au sein d'une plage de fréquences et d'éliminer un bruit électrique, et
- une unité de reconnaissance (3), ladite unité de reconnaissance (3) comprenant :
- un premier module (4) de post-traitement de signaux de décharge partielle pour le post-traitement (13) du signal PD prétraité acquis par le biais du capteur (1) par l'obtention d'un scalogramme de signal PD sur la base d'une transformée en ondelettes, et
- un deuxième module (5) de réseau neuronal pour la reconnaissance (17) de l'image de scalogramme du signal post-traité de décharge partielle par un réseau neuronal, ledit réseau neuronal de reconnaissance étant un réseau neuronal à convolution.

8. Système de reconnaissance de décharge partielle (2) selon la revendication 7, **caractérisé en ce que** l'unité de reconnaissance (3) comprend un troisième module (6) de bibliothèque de signaux de décharge partielle provenant de sources connues.

9. Système de reconnaissance de décharge partielle (2) selon la revendication 8, **caractérisé en ce que** l'unité de reconnaissance (3) comprend un quatrième module (7) d'entraînement de réseau neuronal à convolution.

10. Système de reconnaissance de décharge partielle (2) selon la revendication 9, **caractérisé en ce que** l'unité de reconnaissance (3) comprend un cinquième module (10) de vérification des décharges partielles reconnues par le deuxième module (5) du réseau neuronal.
